# EUROPÄISCHE PATENTSCHRIFT

(11) **EP 3 660 603 B1**
(45) Veröffentlichungstag und Bekanntmachung des Hinweises auf die Patenterteilung: **27.12.2023**
(21) Anmeldenummer: 19207787.3
(22) Anmeldetag: 07.11.2019
(51) Int. Cl.: G05B 19/042, H05K 7/14

(54) **BUSFÄHIGES ANEINANDERREIHBARES FUNKTIONSMODUL**
BUS-CAPABLE FUNCTIONAL MODULES THAT CAN BE CONNECTED TO ONE ANOTHER
MODULE FONCTIONNEL POUVANT ÊTRE DISPOSÉ EN RANG, ADAPTÉ BUS

(30) Priorität: 30.11.2018 DE 202018106823 U
(43) Veröffentlichungstag der Anmeldung: 03.06.2020
(73) Patentinhaber: Weidmüller Interface GmbH & Co. KG, 32758 Detmold (DE)
(72) Erfinder: SCHNATWINKEL, Michael, 32051 Herford (DE); NIGGEMANN, Matthias, 32694 Dörentrup (DE); ROSE, Gorm, 33100 Paderborn (DE); STRÜNKMANN, Marc, 33104 Paderborn (DE)
(74) Vertreter: Kleine, Hubertus

(56) Entgegenhaltungen:
- EP-A1- 2 589 276
- EP-B1- 2 589 276
- DE-A1-102015 104 290
- DE-U1-202013 104 464

## Beschreibung

Die Erfindung betrifft ein busfähiges aneinanderreihbares Funktionsmodul zur Steuerung und/oder Überwachung technischer Prozesse, insbesondere in industriellen Automatisierungseinrichtungen, über einen Funktionsschaltkreis, wobei das Funktionsmodul zur Befestigung an einer Montagebasis eingerichtet ist, vorzugsweise mit Rastmitteln zum Aufrasten auf eine Tragschiene, und wenigstens einen oder mehrere Busleiterkontakte aufweist und mindestens zwei Anschlussbereiche, über die der Funktionsschaltkreis kontaktierbar ist, sowie eine Anschlusseinheit, die mindestens eine Einsteckmöglichkeit für zumindest einen Anschlussbaustein bereitstellt.

In industriellen Automatisierungseinrichtungen werden Steuerungsdaten und/oder Messwerte über einen Feldbus zwischen einem oder mehreren zentralen Steuerungsrechnern, auch Leitrechner oder speicherprogrammierbare Steuerung (SPS) genannt, und Feldgeräten ausgetauscht. Häufig wird dabei nicht jedes einzelne Feldgerät unmittelbar an den Feldbus angeschlossen, sondern über einen sogenannten Feldbuskoppler, auch Gateway genannt, der eine Datenschnittstelle zwischen dem Feldbus einerseits und einem häufig proprietären Subbus, auch Rückwandbus genannt, andererseits darstellt.

Zum Auslesen von Sensordaten oder Schaltinformationen einerseits und zum Ausgeben von Stellgrößen oder ähnlichen Ausgangsgrößen zur Steuerung einer automatisierten Anlage werden die eingangs genannten Funktionsmodule verwendet. Üblicherweise werden die Module über den genannten Feldbuskoppler an den Feldbus angeschlossen. Es ist jedoch auch eine unmittelbare Anbindung an einen Feldbus möglich.

Derartige Funktionsmodule sind beispielsweise aus den Druckschriften EP 0 364 618 B1, EP 2 589 276 B1 und DE 10 2015 104 290 A1 bekannt. Bezüglich ihrer Funktionalität sind verschiedenste Funktionsmodule bekannt, beispielsweise Module, die digitale und/oder analoge Ein- und/oder Ausgabekanäle bereitstellen, Relaisbausteine, Zählerbausteine, Interface-Module und so weiter. Zusammenfassend wird das System aus Feldbuskopplern und angeschlossenen busfähigen Funktionsmodulen auch als modulares dezentrales ("Remote") I/O (Input/Output)-System bezeichnet.

Die in der Druckschrift DE 10 2015 104 290 A1 beschriebenen Funktionsmodule weisen fest integrierte Anschlussmöglichkeiten für Leiter auf. Um eine hohe Flexibilität hinsichtlich anzuschließender Leiter mit oder ohne Steckverbinder und auch hinsichtlich der eingesetzten Signalgrößen zu ermöglichen, ist aus der Druckschrift EP 2 589 276 B1 ein Funktionsmodul bekannt, bei dem verschiedene Anschlussbausteine in eine Anschlussleiste eingesetzt werden können, die dann als Anschlussebene auf das Funktionsmodul aufgesetzt, insbesondere aufgeschwenkt werden kann. Das Funktionsmodul kann so beispielsweise durch den Einsatz unterschiedlicher Anschlussmodule an unterschiedliche Leiterdurchmesser und/oder Steckernormen angepasst werden.

Die Druckschrift DE 20 2013 104 464 U1 zeigt eine Weiterbildung eines derartigen Funktionsmoduls, das eine zusätzliche Leiterkarte aufweist, die kundenspezifische elektrische und/oder elektronische Komponenten aufnehmen kann, durch die Ein- und/oder Ausgangssignale vorverarbeitet werden können.

Die Anschlussbausteine bieten eine hohe Flexibilität bei der Nutzung verschiedener Leiter- und/oder Steckverbindertechniken. Innerhalb des Funktionsmoduls kontaktieren die Anschlussbausteine eine gemeinsame Hauptleiterplatte, die die eigentliche Funktionalität des Funktionsmoduls bereitstellt. Die Hauptleiterplatte erstreckt sich üblicherweise über die im Wesentlichen gesamte Breite des Funktionsmoduls, sodass sie von jedem Anschlussbaustein, beispielsweise durch einen Leiterplattenrandverbinder, kontaktiert werden kann.

Auf der genannten Hauptleiterplatte ist die Basisfunktionalität des Funktionsmoduls in Schaltkreisen umgesetzt, die nachfolgend Funktionsschaltkreise genannt werden. Wenn das Funktionsmodul beispielsweise ein Ausgangsmodul mit einer Mehrzahl von digitalen oder analogen Ausgängen ist, so sind auf der Leiterplatte Funktionsschaltkreise vorgesehen, die abhängig von den Bussignale die entsprechende Mehrzahl von Ein- und Ausgabesignalen ausgibt bzw. einliest. Weiterhin ist auf dieser Hauptleiterplatte eine Busanschaltung angeordnet, die die Funktionsschaltkreise mit den Buskontakten des Funktionsmoduls und damit dem Subbus koppelt. Weiterhin kontaktiert die Hauptleiterplatte den Stromversorgungsbus des Funktionsmoduls, um seine eigenen Elektronickomponenten und gegebenenfalls Ausgänge mit Betriebsstrom zu versorgen.

Die Hauptleiterplatte ist dabei (gegebenenfalls mitsamt schützenden Gehäuseelementen), entnehmbar in dem Funktionsmodul angeordnet und kontaktiert einerseits einen im Rahmen des Funktionsmoduls angeordneten Steckverbinder, über den die Verbindungen zu den Daten- und Stromversorgungsbuskontakten hergestellt werden, und kontaktiert an einer gegenüberliegenden Kante die Anschlussmodule.

Bei gleichem Grundaufbau des Funktionsmoduls kann bei diesem modularen Aufbau durch Auswahl der entsprechenden Hauptleiterkarte die Grundfunktionalität des Funktionsmoduls ausgewählt werden. Durch Verwendung geeigneter und gegebenenfalls unterschiedlicher Anschlussmodule kann flexibel eine geeignete Anschlusstechnik verwendet werden.

Trotz der großen Modularität und Flexibilität, die dieser Aufbau bietet, wird die Grundfunktionalität des gesamten Funktionsmoduls durch Auswahl der Hauptleiterplatte festgelegt. Wenn jeweils für alle Anschlussmodule eine gleiche Grundfunktionalität benötigt wird, ist dieses unproblematisch, da Hauptleiterplatten für gleiche Funktionalität aller Anschlussmodule üblicherweise in einem Sortiment eines Herstellers angeboten werden. So werden Hauptleiterplatten vorgehalten, die digitale Ein- oder Ausgänge für alle Anschlussmodule bereitstellen. Ebenso werden Hauptleiterplatten angeboten, die analoge Ein- oder Ausgänge für alle Anschlussmodule bereitstellen. Auch sind im Allgemeinen Hauptleiterplatten im Sortiment, die Motortreiber, zum Betreiben von beispielsweise je einem Schrittmotor pro Anschlussmodul, ermöglichen.

Wenn, insbesondere bei einem kleineren Automatisierungssystem, zwar verschiedene Funktionalitäten benötigt werden, jeweils pro Funktionalität jedoch nur wenige Anschlussmodule oder nur ein einziges Anschlussmodul, so wird dieses nur in den seltensten Fällen vom Sortiment eines Herstellers abgedeckt. Die Anzahl der zu entwickelnden Hauptplatinen, die an den verschiedenen Anschlussmodulen verschiedene gewünschte Funktionalitäten bereitstellen, wäre unüberschaubar groß und würde die Entwicklungskosten für das Sortiment für den Hersteller untragbar erhöhen.

Es ist daher eine Aufgabe der vorliegenden Erfindung, ein Funktionsmodul der eingangs genannten Art bereitzustellen, bei dem auf einfache Weise verschiedene Funktionalitäten kombiniert bereitgestellt werden können.

Diese Aufgabe wird durch ein Funktionsmodul mit den Merkmalen des unabhängigen Anspruchs gelöst. Vorteilhafte Ausgestaltungen und Weiterbildungen sind in den abhängigen Ansprüchen angegeben.

Ein erfindungsgemäßes Funktionsmodul der eingangs genannten Art zeichnet sich dadurch aus, dass es mindestens zwei separat entnehmbare Funktionseinheiten aufweist, denen jeweils mindestens einer der Anschlussbereiche zugeordnet ist und die jeweils mindestens einen Funktionsschaltkreis umfassen, wobei jeweils einem der separaten Funktionsschaltkreise eine der Einsteckmöglichkeiten für einen der Anschlussbausteine zugeordnet ist, um die separaten Funktionsschaltkreise in den Anschlussbereichen zu kontaktieren.

Anstelle einer gemeinsamen Hauptleiterplatte, auf der die Funktionselektronik angeordnet ist, werden erfindungsgemäß separate Funktionsschaltkreise eingesetzt, die entnehmbar, z.B. ein- bzw. aussteckbar, sind und daher unabhängig voneinander ausgewählt werden können. So können in einem Funktionsmodul verschiedene Funktionalitäten flexibel kombiniert werden. Die Funktionsschaltkreise der Funktionseinheiten können z.B. Ein- und/oder Ausgabebausteine zur Ein- oder Ausgabe von digitalen oder analogen Signalen, eine Motorsteuerung, eine Schnittstelleneinheit (Interface) für eine drahtgebunden oder drahtlos arbeitende Datenschnittstelle und/oder einen Computerelement, beispielsweise einen Embedded-Controller, umfassen.

Die einsteckbaren Anschlussbausteine ermöglichen eine flexibel konfigurierbare Kontaktierung der Funktionsschaltkreise. Zudem wird das sogenannte Rangieren, d.h. das Anbinden einer Steuerung an die zu steuernde Anlage, vereinfacht. Leitungen von Sensoren und/oder Aktoren können unmittelbar bis die Anschlussbausteine geführt werden, die dann nach erfolgter Vorverdrahtung einfach in das Anschlussmodul eingesteckt werden können. Auf Zwischenebenen, z.B. bereitgestellt durch Rangierklemmen, kann verzichtet werden. Bevorzugt sind die mindestens zwei Anschlussbereiche gleich groß ausgebildet, so dass prinzipiell - soweit elektrisch möglich und sinnvoll - die Anschlussmodule an jedem der Anschlussbereiche eingesetzt werden können.

Erfindungsgemäß ist jeweils einem der separaten Funktionsschaltkreise eine der Einsteckmöglichkeiten für einen der Anschlussbausteine zugeordnet, über den die separaten Funktionsschaltkreise in den Anschlussbereichen kontaktierbar sind. Zu jedem Funktionsschaltkreis kann so individuell ein geeignetes Anschlussmodul ausgewählt und eingesetzt werden.

In einer vorteilhaften Ausgestaltung weist das Funktionsmodul eine Verteilerleiterplatte mit mindestens zwei Steckverbindern auf, in die die Funktionseinheiten mit einem korrespondierenden Steckverbinder einsteckbar sind, und die mindestens einen der Busleiterkontakte kontaktiert. Die Verteilerleiterplatte stellt somit eine gemeinsame Basis für die Funktionsmodule dar. Gleichermaßen von allen Funktionseinheiten benötigte Baugruppen oder Verschaltungen können so platz- und kostensparend realisiert und gemeinsam von allen Funktionseinheiten genutzt werden. Bevorzugt weist die Verteilerleiterplatte z.B. eine Busanschaltung auf, über die ein externer Datenbus, der über die Busleiterkontakte geführt ist, auf einen internen Datenbus umgesetzt wird. Der interne Datenbus verbindet jede der Funktionseinheiten mit der Busanschaltung. Der interne Datenbus ein elektrischer (d.h. mittels Leitungen) und/oder ein optischer Bus sein.

In einer weiteren vorteilhaften Ausgestaltung weist jede Funktionseinheit des Funktionsmoduls eine Leiterplatte auf, die an einer Kante den Steckverbinder aufweist und an einer gegenüberliegenden Kante einen der Anschlussbereiche zur Verbindung mit dem Anschlussbaustein. In dem Anschlussbereich sind Anschlusskontakte zur Verbindung mit dem Anschlussbaustein vorgesehen.

Die Erfindung wird nachfolgend anhand von Ausführungsbeispielen mithilfe von Figuren näher erläutert. Die Figuren zeigen:
- Fig.1a, 1b: ein Funktionsmodul gemäß dem Stand der Technik;
- Fig. 2a, 2b: ein zusammengesetztes Funktionsmodul mit Funktionseinheiten und Anschlussbausteinen in einer isometrischen Gesamtansicht (Fig.2a) und einer Ansicht mit teilweise geöffnetem Gehäuse (Fig.2b);
- Fig. 3: eine Darstellung des Funktionsmoduls gemäß Fig. 2b mit entnommenen Anschlussbausteinen;
- Fig. 4: eine Darstellung des Funktionsmoduls analog zu Fig. 2a mit entnommenen Anschlussbausteinen und entnommenen Funktionseinheiten; und
- Fig. 5: ein Blockschaltbild eines Funktionsmoduls.

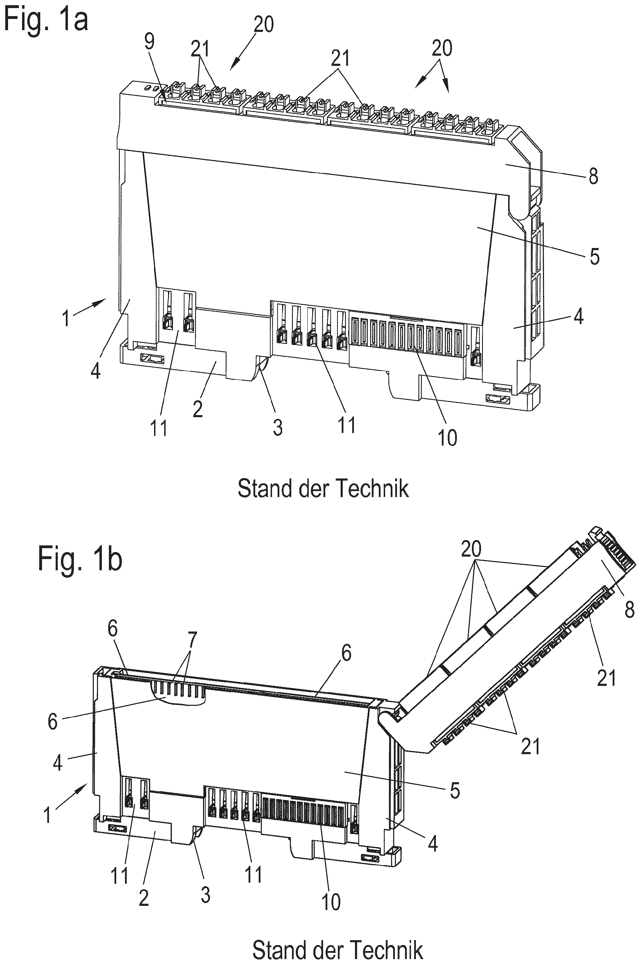

In den Figuren 1a und 1b ist in einer vereinfachten schematischen und perspektivischen Darstellung ein Funktionsmodul 1 gemäß dem Stand der Technik dargestellt. Das gezeigte Funktionsmodul 1 ist auf eine Tragschiene aufsetzbar, insbesondere aufrastbar und auf der Tragschiene aneinanderreihbar, beispielsweise als Teil eines Steuerungssystems in der industriellen Automatisierungstechnik.

Das Funktionsmodul 1 weist einen Basisklemmenträger 2 auf, der mit Rastmitteln 3 zum Aufrasten auf eine hier nicht dargestellte Tragschiene versehen ist. Die Erfindung ist jedoch nicht auf eine derartige Ausgestaltung des Funktionsmodul 1 beschränkt. Sie eignet sich weiter auch für aneinanderreihbare Funktionsmodule 1, die auf einer anderen Montagebasis als einer Tragschiene, beispielsweise einer Wand oder dergleichen, montierbar sind.

Auf dem Basisklemmenträger 2 sind Seitenteile 4 angeordnet, zwischen denen eine Elektronikeinheit angeordnet ist. Die Elektronikeinheit umfasst eine bevorzugt eingeschobene Leiterplatte 6 (vgl. Fig. 1b). Zu beiden Seiten der Leiterplatte 6 sind Seitendeckel 5 angeordnet. Es ist auch möglich, dass die Elektronikeinheit aus einem Gehäuse mit integrierter Leiterplatte 6 besteht.

Auf die Seitenteile 4 und die Elektronikeinheit bzw. die Seitendeckel 5 ist eine Funktionseinheit 8 aufgesetzt, die in dem dargestellten Beispiel schwenkbar mit einem der Seitenteile 4 verbunden ist und an dem anderen Seitenteil 4 festgelegt werden kann. Die Anschlusseinheit 8 weist eine Anzahl von hier vier Öffnungen 9 auf, in die Anschlussbausteine 20 eingesteckt sind, die zum einen die Leiterplatte 6 über die Anschlusskontakte 7 kontaktieren und zum anderen von außen zugängliche Anschlüsse 21 zur Verbindung des Anschluss- und/oder Funktionsmoduls 1 mit externen Leitern bereitstellen.

Im dargestellten Beispiel sind vier identische Anschlussbausteine 20 vorgesehen, die in einer Reihe je vier Anschlussmöglichkeiten bereitstellen. Die Anschlüsse 21 sind vorliegend in Direktstecktechnik (Push-In) ausgeführt, bei denen eine elektrische und mechanische Verbindung des Leiters werkzeugfrei, rein durch Einstecken des Leiters in einen Klemmstellenbereich des Anschlusses 21 hergestellt wird. Es versteht sich, dass je nach Ausgestaltung des Anschluss- und/oder Funktionsmoduls 1 und der Anschlussbausteine 20 die Anschlüsse 21 nicht nur einreihig, sondern mehrreihig vorgesehen sein können. Auch können Anschlussbausteine mit anderen als Push-In-Anschlüssen ausgebildet sein, beispielsweise mit Schneidklemm-Anschlüssen (IDC - Insulation-Displacement Connector), Zugfederanschlüssen oder Schraubanschlüssen.

Die Anschlussmodule 20 bieten eine große Flexibilität in der Kontaktierung des Funktionsmoduls 1, da sie in unterschiedlicher Ausgestaltung der Anschlüsse 21 bereitgestellt werden können. Beispielsweise können Anschlussbausteine 20 mit Anschlüssen 21 für verschiedene Leiterdurchmesser vorgesehen sein, oder auch Anschlussbausteine 20, die Steckverbinder verschiedenster Art aufweisen.

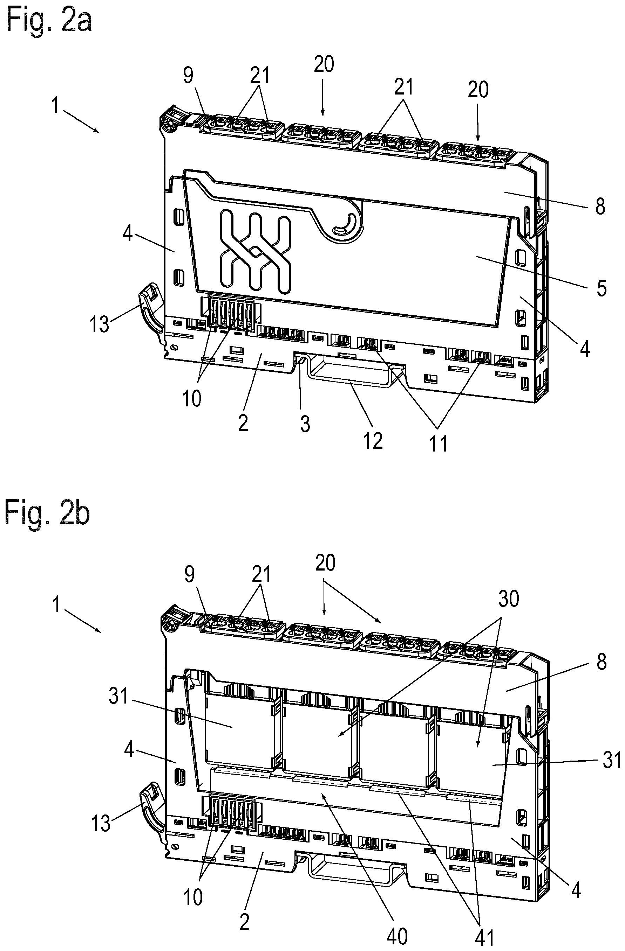

In Fig. 2a ist ein anmeldungsgemäßes Funktionsmodul 1 dargestellt, das vergleichbar zum Funktionsmodul der Fig.1 einen Basisklemmenträger 2 aufweist, der mithilfe von Rastmitteln 3 auf eine Tragschiene 12, hier eine Hutschiene, aufgerastet werden kann. Zum Lösen des Funktionsmoduls 1 ist ein Entriegelungshebel 13 vorgesehen. Auf dem Basisklemmenträger 2 ist ein u-förmiger Träger mit Seitenteilen 4 und Seitendeckeln 5 eingesetzt sind.

Wiederum ist eine Anschlusseinheit 8 vorgesehen, in die Anschlussbausteine 20 in hier vier Steckplätze eingesteckt werden können. Die Anschlusseinheit 8 ist in Form eines Bügels ausgebildet, der von einem bis zum anderen Seitenteil 4 reicht und auf diese Seitenteile 4 aufgerastet oder, besonders bevorzugt, aufgeschwenkt und aufgerastet ist.

Es sind verschiedene Buskontaktelement 10, 11 im Basisklemmenträger 2 bzw. in dem u-förmigen Rahmen zwischen den Seitenteilen 4 ausgebildet, von denen die Buskontaktelemente 10 Kontakte eines hier fünfpoligen Datenbusses darstellen und die Buskontaktelemente 11 Stromversorgungskontakte eines Stromversorgungsbusses.

Das dargestellte Funktionsmodul 1 ist beispielsweise ein Ein- oder Ausgabemodul einer Ein- bzw. Ausgabestation, die eine Kopfstation, auch Buskoppler genannt aufweist, an die sich eine Mehrzahl derartiger Funktionsmodule 1 anreiht. Eine solche Station wird auch als Remote-I/O Station bezeichnet. Sie nimmt Signale an den Anschlussbausteinen 20 entgegen oder gibt Steuersignale oder auch Schaltsignale an den Anschlussbausteinen 20 aus, um eine Industrieanlage zu steuern. Über die Kopfstation sind die Funktionsmodule 1 datentechnisch an einen Feldbus angekoppelt.

Fig. 2b zeigt das Funktionsmodul 1 der Fig. 2a ohne die Seitendeckel 5, um Einblick in den inneren Aufbau des Funktionsmoduls 1 zu geben.

Anders als beim Stand der Technik ist keine gemeinsame Hauptleiterplatte 6 (vgl. Fig. 1b) vorhanden, die einerseits mit den Buskontaktelementen 10, 11 verbunden ist und andererseits die Anschlussbausteine 20 kontaktiert.

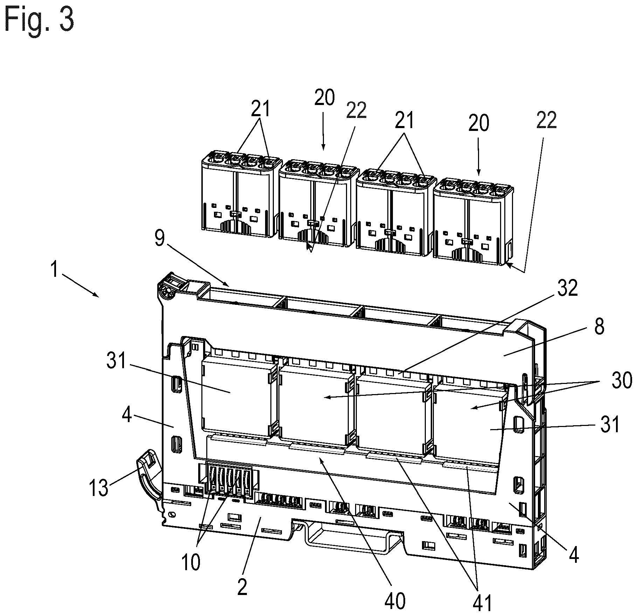

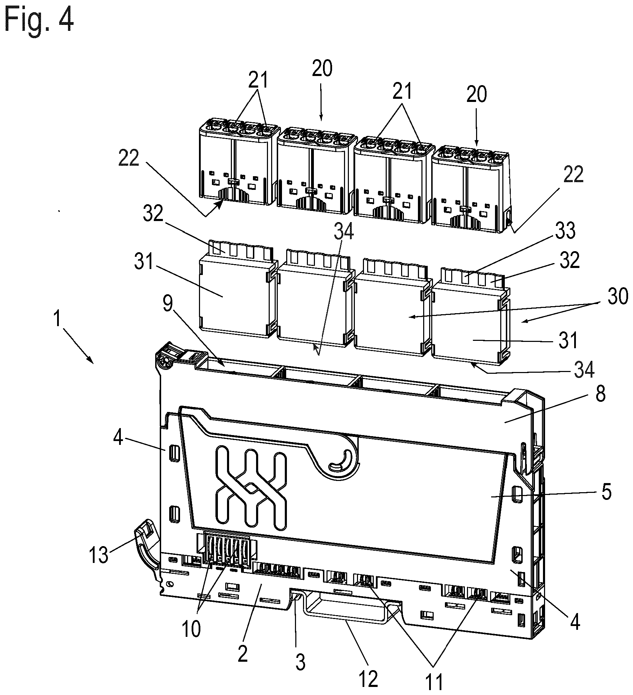

Stattdessen ist für jeden der Anschlussbausteine 20 eine Funktionseinheit 30 vorgesehen, die jeweils ein Gehäuse 31 mit einer davon umfassten Leiterplatte 32 aufweist. Nach oben hin steht die Leiterplatte 32 aus dem Gehäuse 31 heraus, wobei in einem Anschlussbereich Anschlusskontakte 33 auf der Leiterplatte 30 freigelegt sind, die von dem jeweiligen Anschlussbaustein 20 durch einen Leiterplattenrandverbinder 22 (vgl. Figuren 3 und 4) kontaktiert werden. Nach unten, in Richtung des Basisklemmenträgers 2, ist an jeder der Funktionseinheiten 30 ein Steckverbinder 34 (vgl. Fig. 4) angeordnet, dessen Steckkontakte mit der Leiterplatte 32 verbunden sind.

Unterhalb der Funktionseinheit 30 ist eine sich über die im Wesentlichen gesamte Breite des Funktionsmoduls 1 erstreckende Verteilerleiterplatte 40 angeordnet, die Steckverbinder 41 aufweist, in die die Steckverbinder 34 der Funktionseinheiten 30 eingesteckt sind. Auf der gegenüberliegenden Seite kontaktieren Kontakte der Verteilerleiterplatte 40 die Buskontaktelemente 10 und 11.

In der Fig. 3 ist in gleicher Weise wie in Fig. 2b das Funktionsmodul ohne die Seitendeckel 5 gezeigt, wobei in der Fig. 3 die Anschlussbausteine 20 aus dem Funktionsmodul 1 entnommen dargestellt sind.

Fig. 4 zeigt in gleicher Weise wie Fig. 2a das Funktionsmodul 1 mit sowohl entnommenen Anschlussbausteinen 20, als auch entnommenen Funktionseinheiten 30. In der Fig. 4 sind insbesondere die Anschlusskontakte 33 am oberen Rand der Leiterplatten 32 der Funktionseinheiten 30, die von dem Leiterplattenrandverbinder 22 der Anschlussbausteine kontaktiert werden, gut zu erkennen.

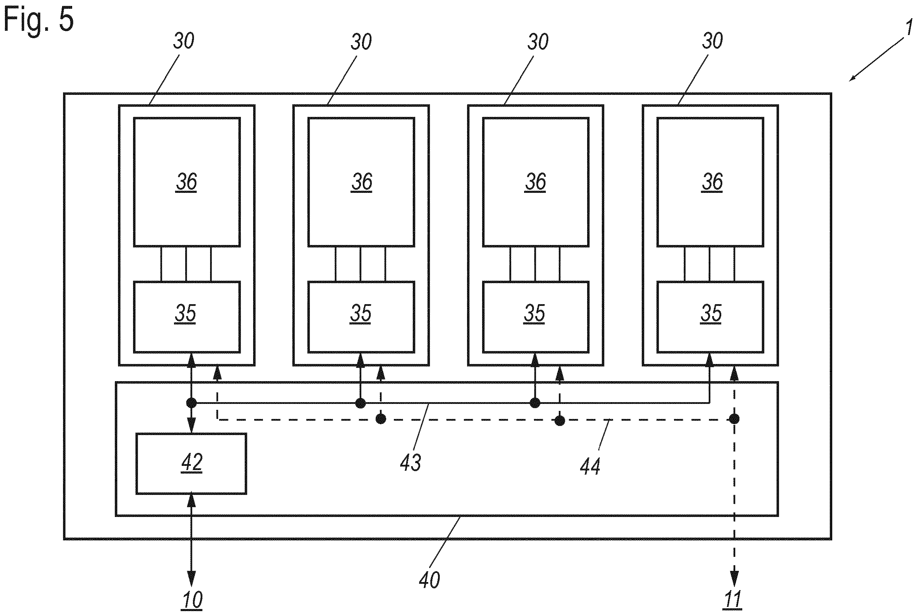

Fig. 5 zeigt in Art eines Blockschaltbilds den elektrischen Aufbau eines anmeldungsgemäßen Funktionsmoduls 1, beispielsweise des in den Fig. 2a, 2b, 3 und 4 dargestellten Funktionsmoduls.

Auf der gemeinsamen Verteilerleiterplatte 40 ist eine gemeinsam von allen Funktionseinheiten 30 genutzte Busanschaltung 42 vorhanden. Diese Busanschaltung 42 steht über die Buskontaktelemente 10 des Funktionsmoduls 1 mit einem Datenbus (z.B. dem eingangs genannten Subbus oder Rückwandbus) in Verbindung, den sie auswertet und die empfangenen oder zu sendenden Daten den verschiedenen Funktionseinheiten 30 zuordnet.

Mit den Funktionseinheiten 30 ist die Verteilerleiterplatte 40 über einen internen Datenbus 43 und einen internen (Strom-) Versorgungsbus 44 verbunden. Der Datenbus 43 kann sich bezüglich seines Protokolls von dem Datenbus unterscheiden. In einer möglichen Ausgestaltung kann der interne Datenbus 43 auch ein optischer Bus sein, der Daten über Lichtleiterelemente zwischen den Funktionseinheiten 30 und der Verteilerleiterplatte 40 austauscht. Ein solcher optischer Bus stellt vorteilhaft bereits eine galvanisch getrennte Datenübertragung bereit, die, falls gewünscht, andernfalls in den Funktionseinheiten 30 oder auf der Verteilerleiterplatte 40 realisiert werden könnte.

Innerhalb einer jeden Funktionseinheit 30 ist entsprechend eine Busanschaltung 35 für den internen Datenbus 43 vorgesehen, die einen Funktionsschaltkreis 36 innerhalb der Funktionseinheit 30 ansteuert. Je nach gewünschter Funktionalität der Funktionseinheit 30 kann der Funktionsschaltkreis 36 beispielsweise ein digitaler oder analoger Ein- und/oder Ausgabebaustein sein oder eine Motorsteuerung, eine drahtgebunden oder drahtlos arbeitende Schnittstelleneinheit oder ein Computermodul, das z.B. einen Embedded-Controller aufweist, usw.

Der anmeldungsgemäße Aufbau des Funktionsmoduls 1 setzt somit eine in der Ebene der Anschlussbausteine 20 realisierbare Modularität bis in die Ebene der Funktionseinheiten 30 und damit der Funktionsschaltkreise 36 fort.

Anstelle der gemeinsamen Hauptleiterplatte, die gemäß dem Stand der Technik die Funktion der Busanschaltung und der Funktionselektronik vereint, ist anmeldungsgemäß die gemeinsame Verteilerleiterplatte 40 vorgesehen, die die Funktionalität der Busanschaltung und der Verteilung der Stromversorgung gemeinsam für die Funktionseinheiten 30 vornimmt. Die eigentliche Funktionalität des Funktionsmoduls 1 wird jedoch modular und somit flexibel individuell kombinierbar von den verschiedenen Funktionseinheiten 30 bereitgestellt. Es wird so eine höhere Flexibilität beim Konfektionieren der Funktionsmodule 1 erzielt. Anmeldungsgemäße Funktionsmodule 1 können verschiedenen Aufgaben (Funktionalitäten) des Remote-I/O Systems in einem Modul kombinieren, ohne dass dafür eine Vielzahl von Hauptplatinen mit verschiedensten Mischfunktionalitäten vorzuhalten ist.

### Bezugszeichen

- 1: Funktionsmodul
- 2: Basisklemmenträger
- 3: Rastmittel
- 4: Seitenteil
- 5: Seitendeckel
- 6: gemeinsame Hauptleiterplatte
- 7: Anschlusskontakt
- 8: Anschlusseinheit
- 9: Öffnung
- 10, 11: Bus-Kontaktelemente
- 12: Tragschiene
- 13: Entriegelungshebel

- 20: Anschlussbaustein
- 21: Anschluss
- 22: Leiterplattenrandverbinder

- 30: Funktionseinheit
- 31: Gehäuse
- 32: Leiterplatte
- 33: Anschlusskontakt
- 34: Steckverbinder
- 35: Busanschaltung
- 36: Funktionsschaltkreis

- 40: Verteilerleiterplatte
- 41: Steckverbinder
- 42: Busanschaltung
- 43: interner Datenbus
- 44: interner Versorgungsbus

## Patentansprüche

1. Busfähiges aneinanderreihbares Funktionsmodul (1) zur Steuerung und/oder Überwachung technischer Prozesse, insbesondere in industriellen Automatisierungseinrichtungen, über einen Funktionsschaltkreis (36), wobei das Funktionsmodul (1) zur Befestigung an einer Montagebasis eingerichtet ist, vorzugsweise mit Rastmitteln (3) zum Aufrasten auf eine Tragschiene (12), und wenigstens einen oder mehrere Busleiterkontakte (10, 11) aufweist und mindestens zwei Anschlussbereiche, über die der Funktionsschaltkreis (36) kontaktierbar ist, sowie eine Anschlusseinheit (8), die mindestens eine Einsteckmöglichkeit für zumindest einen Anschlussbaustein (20) bereitstellt, **dadurch gekennzeichnet, dass** das Funktionsmodul (1) mindestens zwei separat entnehmbare Funktionseinheiten (30) aufweist, denen jeweils mindestens einer der Anschlussbereiche zugeordnet ist und die jeweils mindestens einen Funktionsschaltkreis (36) umfassen, wobei jeweils einem der separaten Funktionsschaltkreise (36) eine der Einsteckmöglichkeiten für einen der Anschlussbausteine (20) zugeordnet ist, um die separaten Funktionsschaltkreise (36) in den Anschlussbereichen zu kontaktieren.

2. Busfähiges aneinanderreihbares Funktionsmodul (1) nach Anspruch 1, bei dem die mindestens zwei Anschlussbereiche gleich groß sind.

3. Busfähiges aneinanderreihbares Funktionsmodul (1) nach Anspruch 1 oder 2, aufweisend eine Verteilerleiterplatte (40) mit mindestens zwei Steckverbindern (41), in die die Funktionseinheiten (30) mit einem korrespondierenden Steckverbinder (34) einsteckbar sind, und die mindestens einen der Busleiterkontakte (10, 11) kontaktiert.

4. Busfähiges aneinanderreihbares Funktionsmodul (1) nach Anspruch 3, bei dem die Verteilerleiterplatte (40) eine Busanschaltung (42) aufweist, über die ein externer Datenbus, der über die Busleiterkontakte (10, 11) geführt ist, auf einen internen Datenbus (43) umgesetzt wird.

5. Busfähiges aneinanderreihbares Funktionsmodul (1) nach Anspruch 4, bei dem der interne Datenbus (43) jede Funktionseinheit (30) mit der Busanschaltung (42) verbindet.

6. Busfähiges aneinanderreihbares Funktionsmodul (1) nach Anspruch 5, bei dem der interne Datenbus (43) ein elektrischer und/oder ein optischer Bus ist.

7. Busfähiges aneinanderreihbares Funktionsmodul (1) nach einem der Ansprüche 3 bis 6, bei dem jede Funktionseinheit (30) eine Leiterplatte (32) aufweist, die an einer Kante den Steckverbinder (34) aufweist und an einer gegenüberliegenden Kante einen der Anschlussbereiche zur Verbindung mit dem Anschlussbaustein (20) aufweist.

8. Busfähiges aneinanderreihbares Funktionsmodul (1) nach einem der Ansprüche 1 bis 7, bei dem die Anschlussbereiche Anschlusskontakte (33) zur Verbindung mit dem Anschlussbaustein (20) aufweisen.

9. Busfähiges aneinanderreihbares Funktionsmodul (1) nach einem der Ansprüche 1 bis 8, bei dem der Funktionsschaltkreis (36) einer Funktionseinheit (30) einen Ein- und/oder Ausgabebaustein zur Ein- oder Ausgabe von digitalen oder analogen Signalen umfasst.

10. Busfähiges aneinanderreihbares Funktionsmodul (1) nach einem der Ansprüche 1 bis 9, bei dem der Funktionsschaltkreis (36) einer Funktionseinheit (30) eine Motorsteuerung aufweist.

11. Busfähiges aneinanderreihbares Funktionsmodul (1) nach einem der Ansprüche 1 bis 10, bei dem der Funktionsschaltkreis (36) einer Funktionseinheit (30) ein Schnittstelleneinheit für eine drahtgebunden und/oder drahtlos arbeitende Datenschnittstelle umfasst.

12. Busfähiges aneinanderreihbares Funktionsmodul (1) nach einem der Ansprüche 1 bis 11, bei dem der Funktionsschaltkreis (36) einer Funktionseinheit (30) einen Embedded-Controller umfasst.

## Claims

1. Bus-capable stackable function module (1) for controlling and/or monitoring technical processes, in particular in industrial automation devices, via a function circuit (36), wherein the function module (1) is set up for fastening to a mounting base, preferably with latching means (3) for latching onto a mounting rail (12), and having at least one or more bus line contacts (10, 11) and at least two connection regions via which the function circuit (36) can be contacted, and a connection unit (8), which provides at least one plug-in possibility for at least one connection module (20), **characterized in that** the function module (1) has at least two separately removable function units (30), to each of which at least one of the connection regions is assigned and each of which comprises at least one function circuit (36), wherein in each case one of the plug-in possibilities for one of the connection modules (20) is assigned to one of the separate function circuits (36) in order to contact the separate function circuits (36) in the connection regions.

2. Bus-capable stackable function module (1) according to claim 1, in which the at least two connection regions are of equal size.

3. Bus-capable stackable function module (1) according to claim 1 or 2, comprising a distributor printed circuit board (40) having at least two plug connectors (41), into which the function units (30) can be plugged with a corresponding plug connector (34), and which makes contact with at least one of the bus conductor contacts (10, 11).

4. Bus-capable stackable function module (1) according to claim 3, in which the distributor circuit board (40) has a bus connection circuit (42) via which an external data bus, which is routed via the bus conductor contacts (10, 11), is converted to an internal data bus (43).

5. Bus-capable stackable function module (1) according to claim 4, in which the internal data bus (43) connects each function unit (30) to the bus connection circuit (42).

6. Bus-capable function module (1) according to claim 5, in which the internal data bus (43) is an electrical and/or an optical bus.

7. Bus-capable stackable function module (1) according to one of claims 3 to 6, in which each function unit (30) has a printed circuit board (32) which has the plug connector (34) on one edge and has one of the connection regions for connection to the connection module (20) on an opposite edge.

8. Bus-capable stackable function module (1) according to one of claims 1 to 7, in which the connection regions have connection contacts (33) for connection to the connection module (20).

9. Bus-capable stackable function module (1) according to one of claims 1 to 8, in which the function circuit (36) of a function unit (30) comprises an input and/or output module for inputting or outputting digital or analog signals.

10. Bus-capable stackable function module (1) according to one of claims 1 to 9, in which the function circuit (36) of a function unit (30) has a motor controller.

11. Bus-capable stackable function module (1) according to one of claims 1 to 10, in which the function circuit (36) of a function unit (30) comprises an interface unit for a wired and/or wireless data interface.

12. Bus-capable stackable function module (1) according to one of claims 1 to 11, in which the function circuit (36) of a function unit (30) comprises an embedded controller.

## Revendications

1. Module fonctionnel (1) pouvant être disposé en rang, adapté bus pour la commande et/ou la surveillance de processus techniques, en particulier dans des dispositifs d'automatisation industriels, par l'intermédiaire d'un circuit fonctionnel (36), le module fonctionnel (1) étant conçu pour être fixé sur une base de montage, de préférence avec des moyens d'encliquetage (3) pour l'encliquetage sur un rail porteur (12), et présentant au moins un ou plusieurs contacts de conducteur de bus (10, 11) et au moins deux zones de raccordement par l'intermédiaire desquelles le circuit fonctionnel (36) est contactable, ainsi qu'une unité de raccordement (8), qui met à disposition au moins une possibilité d'enfichage pour au moins un module de raccordement (20), **caractérisé en ce que** le module fonctionnel (1) présente au moins deux unités fonctionnelles (30) retirables séparément, auxquelles est associée respectivement au moins l'une des zones de raccordement et qui comprennent respectivement au moins un circuit fonctionnel (36), l'une des possibilités d'enfichage pour l'un des modules de raccordement (20) étant associée respectivement à l'un des circuits fonctionnels (36) séparés, afin de mettre en contact les circuits fonctionnels (36) séparés dans les zones de raccordement.

2. Module fonctionnel (1) pouvant être disposé en rang, adapté bus selon la revendication 1, dans lequel les au moins deux zones de raccordement sont de même taille.

3. Module fonctionnel (1) pouvant être disposé en rang, adapté bus selon la revendication 1 ou 2, présentant une carte de circuit imprimé de distribution (40) avec au moins deux connecteurs (41), dans lesquels les unités fonctionnelles (30) sont enfichables avec un connecteur (34) correspondant, et qui contacte au moins l'un des contacts de conducteur de bus (10, 11).

4. Module fonctionnel (1) pouvant être disposé en rang, adapté bus selon la revendication 3, dans lequel la carte de circuit imprimé de distribution (40) présente un circuit de bus (42) par lequel un bus de données externe, qui est guidé par les contacts de conducteur de bus (10, 11), est converti en un bus de données interne (43).

5. Module fonctionnel (1) pouvant être disposé en rang, adapté bus selon la revendication 4, dans lequel le bus de données interne (43) relie chaque unité fonctionnelle (30) au circuit de bus (42).

6. Module fonctionnel (1) pouvant être disposé en rang, adapté bus selon la revendication 5, dans lequel le bus de données interne (43) est un bus électrique et/ou un bus optique.

7. Module fonctionnel (1) pouvant être disposé en rang, adapté bus selon l'une des revendications 3 à 6, dans lequel chaque unité fonctionnelle (30) présente une carte de circuit imprimé (32) qui présente sur un bord le connecteur (34) et sur un bord opposé l'une des zones de raccordement pour la liaison avec le module de raccordement (20).

8. Module fonctionnel (1) pouvant être disposé en rang, adapté bus selon l'une des revendications 1 à 7, dans lequel les zones de raccordement présentent des contacts de connexion (33) pour la liaison avec le module de raccordement (20).

9. Module fonctionnel (1) pouvant être disposé en rang, adapté bus selon l'une des revendications 1 à 8, dans lequel le circuit fonctionnel (36) d'une unité fonctionnelle (30) comprend un module d'entrée et/ou de sortie pour l'entrée ou la sortie de signaux numériques ou analogiques.

10. Module fonctionnel (1) pouvant être disposé en rang, adapté bus selon l'une des revendications 1 à 9, dans lequel le circuit fonctionnel (36) d'une unité fonctionnelle (30) présente une commande de moteur.

11. Module fonctionnel (1) pouvant être disposé en rang, adapté bus selon l'une des revendications 1 à 10, dans lequel le circuit fonctionnel (36) d'une unité fonctionnelle (30) comprend une unité d'interface pour une interface de données fonctionnant en mode filaire et/ou sans fil.

12. Module fonctionnel (1) pouvant être disposé en rang, adapté bus selon l'une des revendications 1 à 11, dans lequel le circuit fonctionnel (36) d'une unité fonctionnelle (30) comprend un contrôleur embarqué.
